(19) **Europäisches Patentamt / European Patent Office / Office européen des brevets**

(11) **EP 1 821 368 A1**

(12) # EUROPEAN PATENT APPLICATION
published in accordance with Art. 158(3) EPC

(43) Date of publication:
**22.08.2007 Bulletin 2007/34**

(21) Application number: **06714893.2**

(22) Date of filing: **28.02.2006**

(51) Int Cl.:
*H01R 12/04* (2006.01)    *C25D 7/00* (2006.01)
*H01R 12/16* (2006.01)    *H01R 13/03* (2006.01)
*H01R 13/46* (2006.01)    *H05K 1/14* (2006.01)

(86) International application number:
**PCT/JP2006/303764**

(87) International publication number:
**WO 2006/093155 (08.09.2006 Gazette 2006/36)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **01.03.2005 JP 2005055552**

(71) Applicant: **MATSUSHITA ELECTRIC INDUSTRIAL CO., LTD.**
**Osaka 571-8501 (JP)**

(72) Inventors:
• **YAMAGUCHI, Hiroyuki,**
**c/o Matsushita Electric Ind. Co., Ltd.**
**Chuo-ku, Osaka-shi, Osaka 540-6319 (JP)**

• **NAKANISHI, Kiyoshi,**
**c/o Matsushita Electric Ind. Co., Ltd.**
**Chuo-ku, Osaka-shi, Osaka 540-6319 (JP)**
• **MURAMATSU, Ken,**
**c/o Matsushita Electric Ind. Co., Ltd.**
**Chuo-ku, Osaka-shi, Osaka 540-6319 (JP)**
• **SUZUKI, Hiroyuki,**
**c/o Matsushita Electric Ind. Co., Ltd.**
**Chuo-ku, Osaka-shi, Osaka 540-6319 (JP)**

(74) Representative: **Grünecker, Kinkeldey,**
**Stockmair & Schwanhäusser**
**Anwaltssozietät**
**Maximilianstrasse 58**
**80538 München (DE)**

(54) **CONNECTOR BETWEEN SUBSTRATES, AND CIRCUIT BOARD DEVICE USING CONNECTOR BETWEEN SUBSTRATES**

(57)     An object of the invention is to provide the effects of suppressing noise radiated from a plurality of coupling terminals for coupling between boards to the peripheral space outside of an inter-board coupling connector.

Two boards opposing to each other are electrically coupled by coupling terminals (3a), (3b), (3c) and these coupling terminals are molded by insulative resin to form in a frame shape. When an electric signal passes through the coupling terminals (3a), (3b), (3c), the noise radiated in the peripheral space of the outside can be suppressed by a shield plate (4a), (4b) attached to the outer periphery of the resin.

FIG. 1

**EP 1 821 368 A1**

## Description

<Technical Field>

The present invention relates to an inter-board coupling connector with a shield which has a function of shielding a predetermined area of a space between a pair of printed boards opposing to each other and a function of coupling the coupling terminals of the printed boards, and also relates to a circuit board device using the inter-board coupling connector.

<Background Art>

Conventionally, as a method of shielding circuits and electronic parts mounted on a printed board, there is proposed a method in which a ground pattern is provided at a portion of the printed board opposing to the electronic parts and the circuits and a metal chassis of a rectangular cylindrical shape is provided so as to surround the electronic parts and the circuits each serving as a noise generator, thereby to form a shield (see patent document 1, for example).

Further, in a connector for coupling a high-frequency circuit board, there is proposed a technique in which a shield member covers the periphery of the housing of the connector thereby to reduce the radiation and the linking at the time of using a high-frequency (see patent document 2, for example).

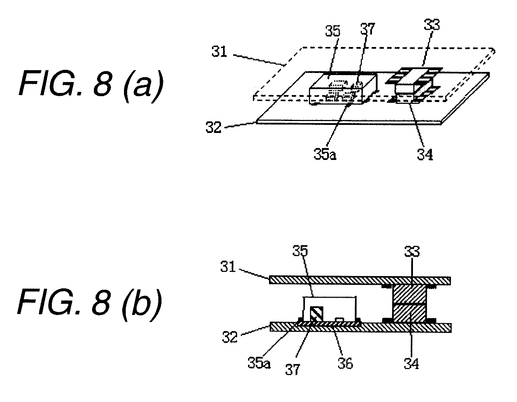

Fig. 8 shows the configuration of a circuit board of a related art, in which Figs. 8(a) and 8(b) show the perspective view and the sectional view thereof, respectively. In Fig. 8, the coupling terminals of a printed board 31 and a printed board 32 are coupled via a connector member 33 and a connector member 34. Each of the connector members 33 and 34 is detachable. A shield case 35 of a box shape covered on the printed board 32 is coupled to a ground pattern6S 1 on the printed board 32 via a ground terminal 35a. According to this configuration, the shield case 35 and the ground pattern6S 1 form the shield thereby to reduce the noise generated outward from the electronic part 37.

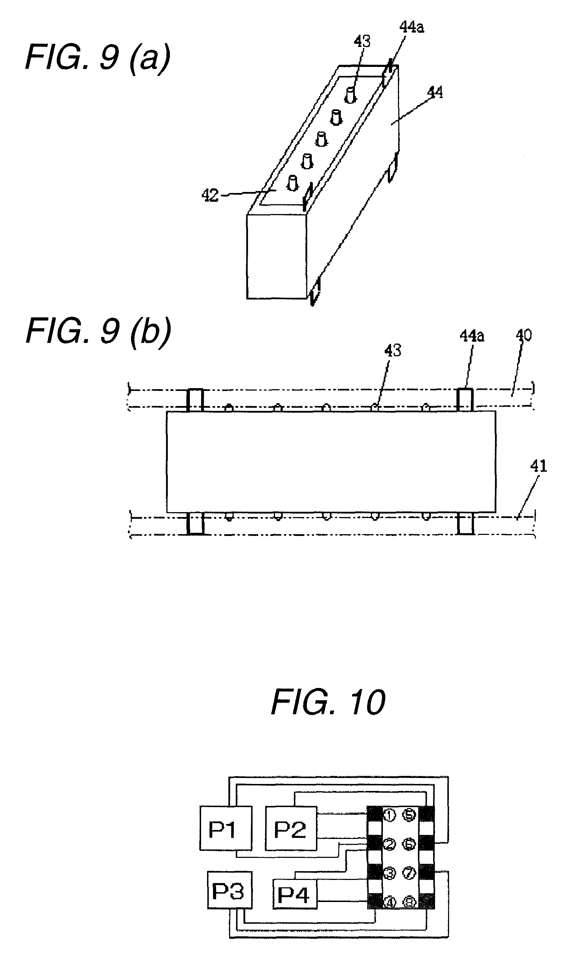

Fig. 9 shows the configuration of an inter-board coupling connector of another related art, in which Figs. 9(a) and 9(b) show the perspective view and the sectional view thereof, respectively. In Fig. 9(b), the conductive portions of a printed board 40 and a printed board 41 are coupled via conductive pins 43 which is biased elastically. The ground portions 44a of a shieldmember 44 are made contact with a pressure to the ground wirings of the printed boards 40, 41. The shield member 44 surrounds the periphery of a housing 42 thereby to reduce the noise radiated from an electric signal passing through the conductive pins 43 to the peripheral space outside of the inter-board coupling connector.

Patent Document 1: JP-A-10-41669 (page 3, Fig. 1)
Patent Document 2: JP-A-2001-244027 (page 4, Fig. 4)

<Disclosure of the invention>

<Problems that the Invention is to Solve>

However, in the circuit board and the inter-board coupling connector of the related art, the inter-board coupling connector and the shield case are provided separately in order to couple the circuits of the printed boards opposing to each other, as shown in Fig. 8. Thus, there arises a problem that the miniaturization of the circuit board device can not be realized since the printed boards require areas for mounting the inner-board coupling connectors 33, 34 as well as areas for the shield case 35, the electronic part 37 and the a circuit for coupling the electronic part 37.

Further, in the case of using the inner-board coupling connectors 33, 34 each being detachable, since the general-purpose connectors are usually used in view of the cost thereof, the number of the terminals of the connector is limited and so there arises a problem that many circuits can not be coupled. Further, when the number of the terminals of the inter-board coupling connector increases, since the density of the printed board circuits at the periphery of the connector increases, there arises a problem that it is difficult to layout the circuits of the printed board.

Further, in the case where the shielding of electronic circuits is required, parts are required to be disposed in a clustered manner in order to house the electronic parts within the shield case, so that there is the restriction in the layout design of the circuit.

Further, in the inter-board coupling connector of the related art as shown in Fig. 9, since the electrical connection between the boards and the electrical connection between the mail and female terminals of the connector are performed via the elastically biased conductive pins, there arises a problem that the high-frequency characteristics is unlikely stable when the connector is used in the high-frequency range of 1.5 GHz or more utilized in a mobile phone etc., for example.

<Means for Solving the Problems>

The inter-board coupling connector according to the invention is arranged to include an inter-board coupling connector main body in which two boards opposing to each other are electrically coupled by a plurality of coupling terminals and the plurality of coupling terminals are molded by insulative resin to form a frame-shaped housing; and a shield plate provided at an outer periphery of the inter-board coupling connector main body, thereby to provide an electric shielding property between the plurality of coupling terminals and an outside of the inter-board coupling connector main body, wherein each of the plurality of coupling terminals is formed by a single metal piece in a manner that the each coupling terminal has flat portions to be joined to the two boards opposing to each other, respectively, and the flat portions protrude from the housing.

According to this configuration, the noise radiated from the coupling terminal of the connector can be suppressed from radiating to the peripheral space of the outside.

In particular, since the housing of the connector is formed in a frame shape, the electronic parts required to be shielded can be mounted within the frame of the connector. Thus, the coupling terminals can be disposed in a widely distributed manner within the frame shaped portion of the housing without being concentrated at the portion of the connector. Accordingly, the degree of freedom of the wiring layout of the circuits of the printed board is high and so the circuit design can be facilitated. Further, since it becomes easy to widen the pitch of the coupling terminals, the joining between the coupling terminals and the wiring pattern can be facilitated.

Further, since the coupling terminal is formed by the single metal piece and the flat portions of the coupling terminal are respectively joined to the two boards opposing to each other by means of the solder, stable high-frequency characteristics can be attained as to each of the signal line and the shielding and simultaneously the miniaturization and the cost-reduction can be performed.

The inter-board coupling connector according to the invention is arranged to further include a space serving as s solder width provided between the flat portion of the coupling terminal and the housing.

According to this configuration, the coupling reliability at the time of the solder reflow can be improved and the stable impedance characteristics can be obtained even in a high-frequency range.

The inter-board coupling connector according to the invention is arranged in a manner that the coupling terminal is formed by phosphor bronze which is subjected to a nickel plating to form a lower layer and subjected to a tin plating to form a major surface layer, and liquid crystal polymer (LCP) is used as the resin for molding the coupling terminals. Thus, since the coupling terminal can secure good spring property, the good soldering property can be provided between the coupling terminal and the board at the time of the reflow process. Further, also since the low dielectric constant and the low dielectric loss can be realized, the increasing of the transmission frequency to the high-frequency.

The circuit board device according to the invention is arranged to include one of the inter-board coupling connectors configured in the aforesaid manner; a first printed board on which electronic parts are mounted within the frame of the inter-board coupling connector; and a second printed board disposed in opposite to the first printed board and coupled thereto via the inter-board coupling connector;, wherein a wiring shield is provided on a major surface layer of the first printed board and on an inner layer of the second printed board, and the electronic parts are surrounded by the inter-board coupling connector and the wiring shields of the first printed board and the second printed board.

According to this configuration, a shield case is not required to be provided separately and the electronic parts are surrounded by the wiring shields of the upper and lower boards and the shield plate provided at the connector, the good shielding property can be obtained. Further, since electronic parts required to be shielded can be mounted on the upper and lower printed boards surrounded by the shield member of the inter-board coupling connector, the mounting efficiency is improved and the restriction of the circuit design is eased thereby to improve the degree of freedom of the design.

<Effects of the Invention>

According to the inter-board coupling connector of the invention, the noise radiated from the coupling terminal can be suppressed from radiating to the peripheral space of the outside and the stable high-frequency characteristics can be attained.

According to the inter-board coupling connector of the invention, the coupling reliability at the time of the solder reflow can be improved and the stable impedance characteristics can be obtained.

According to the inter-board coupling connector of the invention, the good soldering property can be provided between the coupling terminal and the board at the time of the reflow process. Further, also since the low dielectric constant and the low dielectric loss can be realized, the increasing of the transmission frequency to the high-frequency can be realized.

According to the circuit board device of the invention, the circuit board can be miniaturized and the good shielding property can be attained. Further, themountingefficiency can be improved and the restriction of the circuit design can be ease as to the circuit layout of the printed board.

<Brief Description of the Drawings>

Fig. 1 is a perspective view showing the outward appearance of the inter-board coupling connector according to the first embodiment of the invention.

Fig. 2 (a) is the sectional diagram of the inter-board coupling connector according to the first embodiment of the invention cut along a line A-A in Fig. 1, and (b) is the sectional diagram of the inter-board coupling connector according to the first embodiment of the invention cut along a line B-Bin Fig. 1.

Fig. 3 (a) shows a coupling state of the portion corresponding to the section cut along the line A-A in Fig. 1 of the printed board coupled by the inter-board coupling connector according to the first embodiment of the invention, and (b) shows a coupling state of the portion corresponding to the section cut along the line B-B in Fig. 1 of the printed board coupled by the inter-board coupling connector according to the first embodiment of the invention.

Fig. 4 is a pattern diagram showing a coupling state between electronic parts and the inter-board coupling connector according to the invention.

Fig. 5 (a) shows a coupling state of the portion corresponding to the section cut along the line A-A in Fig. 1 of the circuit board device according to the second embodiment of the invention, and (b) shows a coupling state of the portion corresponding to the section cut along the line B-B in Fig. 1 of the circuit board device according to the second embodiment of the invention.

Fig. 6 is a diagram showing the antenna BER characteristics of a mobile phone to which the circuit board device according to the second embodiment of the invention is applied.

Fig. 7 is a diagram showing the antenna BER characteristics of a mobile phone to which the circuit board device of a related art is applied.

Fig. 8 (a) is a perspective view showing the outward appearance of the circuit board device using the inter-board coupling connector of a related art, and (b) is a sectional view showing the circuit board device using the inter-board coupling connector of the related art.

Fig. 9 (a) is a perspective view showing the outward appearance of the inter-board coupling connector of a related art, and (b) is a side view showing the outward appearance of the inter-board coupling connector of the related art.

Fig. 10 is a pattern diagram showing a coupling state between electronic parts and the inter-board coupling connector of a related art.

<Description of the Reference Numerals and Signs>

| 1 | housing |
| 2a, 2b, 2c, 2d, 2e, 2f, 2g, 2h | GND terminal of shield plate |
| 3a, 3b,. 3c, 3d | coupling terminal |
| 4a, 4b | shield plate |
| 5 | flat portion of coupling terminal 3 |
| 6 | space |
| 7, 8 | printed board |
| 9, 10 | conductive portion of printed board |
| 11, 12 | GND terminal of printed board |
| 13, 14 | ground wiring of printed board |
| 15, 16 | electronic part |
| 17, 18 | inner via of printed board |
| 19 | solder |

<Best Mode for Carrying Out the Invention>

Hereinafter, the best mode for carrying out the invention will be explained with reference to the accompanying drawings.

(First Embodiment)

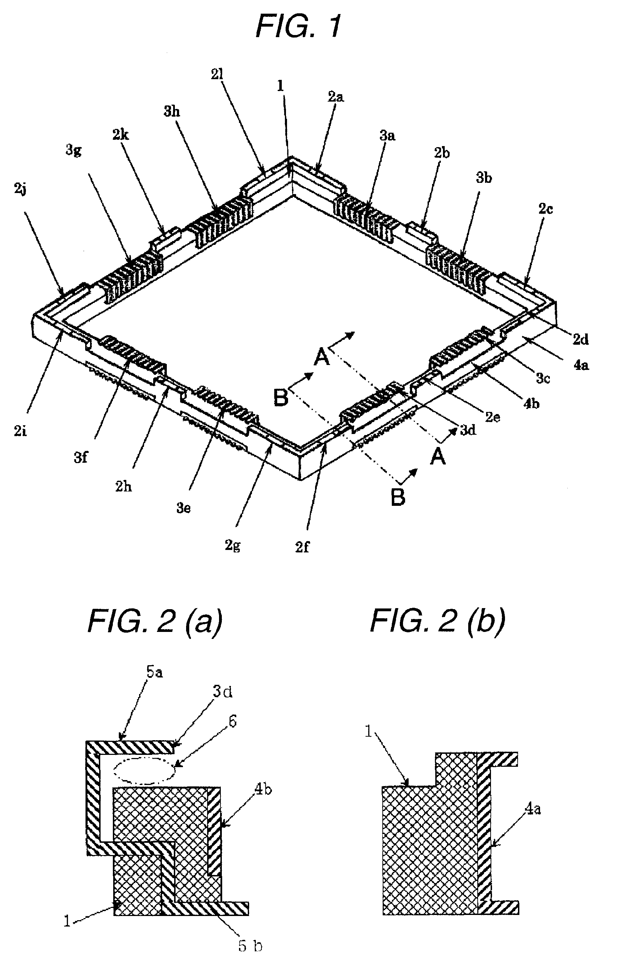

The inter-board coupling connector according to the first embodiment of the invention will be explained. Fig. 1 is a perspective view showing the outward appearance of the inter-board coupling connector according to the first embodiment of the invention. The inter-board coupling connector has the structure of being provided with coupling terminals 3 depicted by 3a to 3h, a housing 1 configured by integrally forming the coupling terminals 3 by insulative resin, and a shield plate 4 provided at the outer periphery of the housing. The shield plate 4 has wide-width portions 4a and narrow-width portions 4b. 2a to 2h depict ground terminals (GNDterminals) formed by bending the shield plate 4. The ground terminals are joined to the ground pattern (GND pattern) of the board via solder. Fig. 2(a) shows the section cut along a line A-A in Fig. 1 and Fig. 2(b) shows the section cut along a line B-B in Fig. 1.

In Fig. 2(a), the coupling terminal 3d is formed by bending a single metal plate and has a first flat portion 5a and a second flat portion 5b. The first flat portion 5a is configured so as to be almost in parallel to the housing 1. A space 6 is provided between the first flat portion 5a and the housing 1. In order to provide the space 6, the portion 4b of the shield plate 4 shown in Fig. 2(a) is made smaller in its width than that of other portion 4a shown in Fig. 2 (b) . The space 6 serves as a solder width or solder area at the time of soldering the inter-board coupling connector to the printed board by the reflow processing. Although the portion 4a shown in Fig. 2(b) is omitted in the perspective view of the outward appearance in Fig. 1, this portion is bent at its upper and lower ends to form in a U shape in its section.

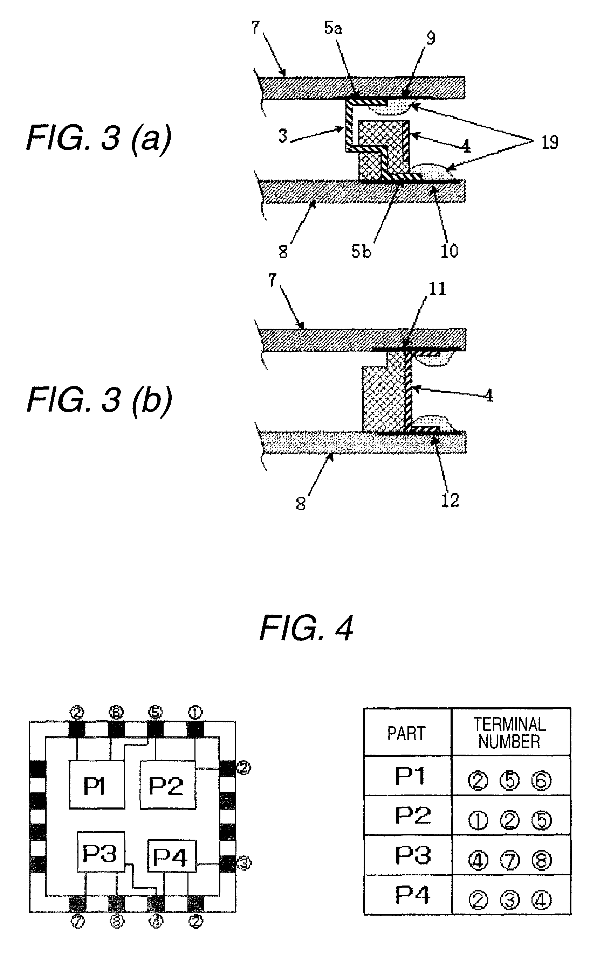

Fig. 3 is sectional views showing a state where the two printed boards are coupled via the inter-board coupling connector. Fig. 3 (a) shows a coupling state of the portion corresponding to the section cut along the line A-A in Fig. 1, and Fig. 3(b) shows a coupling state of the portion corresponding to the section cut along the line B-B in Fig. 1.

As shown in Fig. 3 (a), printed boards 7 and 8 opposing to each other are joined by the solder via the first flat portion 5a and the second flat portion 5b of the coupling terminal 3. Further, as shown in Fig. 3(b), the shield plate 4 is coupled to the GND terminals 11, 12 of the printed boards 7, 8, respectively. According to this configuration, the printed boards 7 and 8 are electrically coupled via the coupling terminal 3, whereby the noise radiated from an electric signal passing through the coupling terminal 3 can be suppressed from radiating to the peripheral space outside of the inter-board coupling connector by the shield plate 4. Further, since the coupling terminal 3 is formed by the single metal piece and the flat portions 5a, 5b of the coupling terminal 3 are joined to the printed boards 7, 8 via the solder, respectively, each of the signal line and the shield can obtain the stable high-frequency characteristics. This is because, since the GND terminals 11, 12 of the printed boards 7, 8 can be coupled at a relatively short distance (for example, $\lambda/50$) from the shield plate 4, the GND terminals 11, 12 of the upper and lower boards likely become same voltage as the shield plate 4 in the high-frequency range, a high-frequency impedance can be made stable. Further, there is a merit that the miniaturization and cost reduction can be realized simultaneously.

Further, according to the embodiment, since the connector is formed in a frame shape, the layout design of the circuit can be facilitated. Fig. 4 is a pattern diagram showing a state in which electronic partsP1 to P4 are mounted within the frame of the inter-board coupling connector and the electronic partsP1 to P4 are coupled to the coupling terminals 1) to 8) of the inter-board coupling connector via a pattern wiring. Fig. 4 shows an example using the inter-board coupling connector of a frame shape. As an example using an inter-board coupling connector of a related art to be compared with this example, Fig. 10 shows a state where the electronic partsP1 to P4 are coupled to the coupling terminals 1) to 8) of the inter-board coupling connector via a pattern wiring.

According to the invention, since the coupling terminals 3 are disposed at the periphery of the housing 1 in an distributed manner as shown in Fig. 4, the wiring density can be made small. In Fig. 4, the part P1 is coupled to the terminals 2), 5) and 6), the part P2 is coupled to the terminals 1), 2) and 5), the part P3 is coupled to the terminals 4), 7) and 8), and the part P4 is coupled to the terminals 2), 3) and 4). Although the terminal 2) is coupled to the three parts P1, P2 and P3, since the three terminals 2) are provided near these three parts, respectively, the simple wiring can be configured. Thus, the degree of freedom of the wire wiring can be improved and, as a result, the degree of freedom of the design such as the part layout can be improved.

However, with reference to Fig. 10 showing a comparative example in which the similar wiring is made in the configuration of the related art, since the general-purpose detachable connector is used, the number of the terminals is limited and so the wiring density becomes large. Thus, it will be understood that the wiring space is further required and so the degree of freedom of the design of the circuit layout is degraded.

In this manner, according to the inter-board coupling connector of the first embodiment of the invention, the noise radiated from the coupling terminals to the peripheral space outside of the inter-board coupling connector can be suppressed, the stable high-frequency characteristics can be obtained and the degree of freedom of the design can be improved.

The inter-board coupling connector according to the invention has the configuration taken into consideration of the characteristic impedance by controlling the terminal width of the coupling terminal, the thickness of resin molding the coupling terminal, the dielectric constant of the resin, and the distance between the coupling terminal and the shield. The characteristic impedance is represented by the following expression.

[Expression 1]

$$\varepsilon re = (\varepsilon r + 1)/2 + \{(\varepsilon r - 1)/2\} \{(1 + 12h/W)^{-1/2}$$

$$+ 0.04 (1 - W/h)^2\} \qquad W/h \leq 1$$

$$= (\varepsilon r + 1)/2 + \{(\varepsilon r - 1)/2\} \{(1 + 12h/W)^{-1/2}$$

$$W/h \geq 1$$

[Expression 2]

$$Z0 = (60/\sqrt{\varepsilon re}) \ln(8h/W + 0.25 W/h)$$

$$W/h \leq 1$$

$$= (120\pi/\sqrt{\varepsilon re}) \{W/h + 1.393 + 0.667\ln(W/h +$$

$$1.444)\}^{-1} \qquad W/h \geq 1$$

Here, $\varepsilon$ re represents an effective relative dielectric constant of the insulative resin and the air, $\varepsilon$ r represents a relative dielectric constant of the insulative resin, ZO represents the characteristic impedance of the inter-board coupling connector, h represents the thickness of the resin and W represents the width of the coupling terminal.

When the connector is configured according to the aforesaid expressions, the characteristic impedance of the inter-board coupling connector can be reduced and the insertion loss in a high-frequency line can be reduced.

(Second Embodiment)

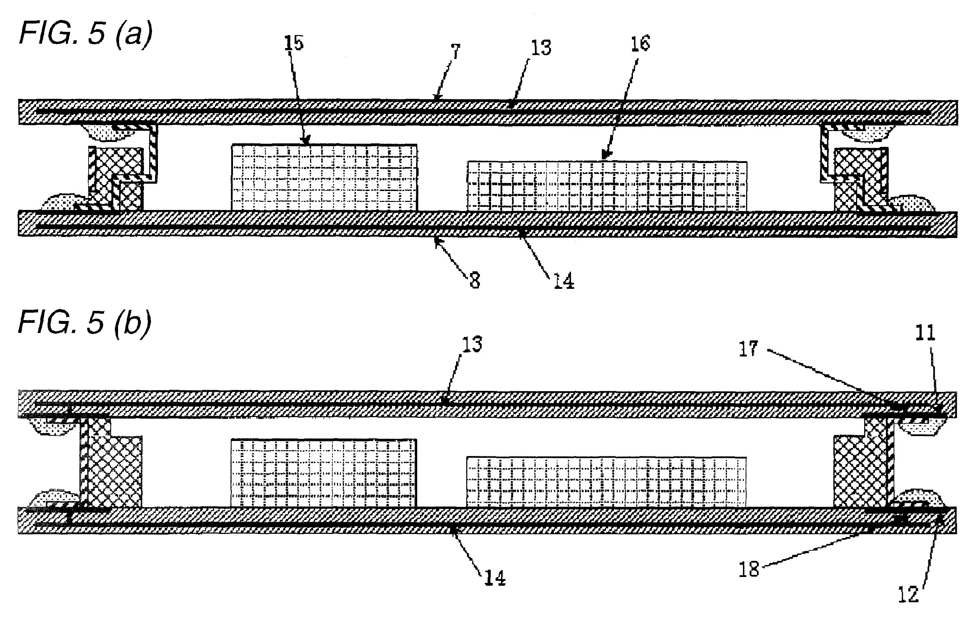

Fig. 5 shows the circuit board device according to the second embodiment. Fig. 5 is sectional diagrams each showing a state where two printed boards 7, 8 are coupled via an inter-board coupling connector, in which Fig. 5(a) shows a coupling state of the portion corresponding to the section cut along the line A-A in Fig. 1 and Fig. 5 (b) shows a coupling state of the portion corresponding to the section cut along the line B-B in Fig. 1. As shown in Fig. 5(a), GND patterns 13, 14 are formed on the inner layer of the printed board 7 and the outer layer of the printed board 8, respectively. The GND patterns 13, 14 and a shield plate 4 are coupled through inner vias 17, 18, thereby to surround electronic parts 15, 16 by the GND patterns 13, 14 and the shield plate 4. Other configuration of this embodiment is same as that of the first embodiment.

According to this configuration, the printed boards 7 and 8 are electrically coupled via the coupling terminals 3, whereby the noise radiated from an electric signal passing through the coupling terminal 3 can be suppressed from radiating to the peripheral space outside of the inter-board coupling connector by the shield plate 4. Since the electronic parts 15, 16 are surrounded by the GND patterns 13, 14 and the shield plate 4, the noise from the electronic parts can be suppressed from radiating to the space outside of the connector.

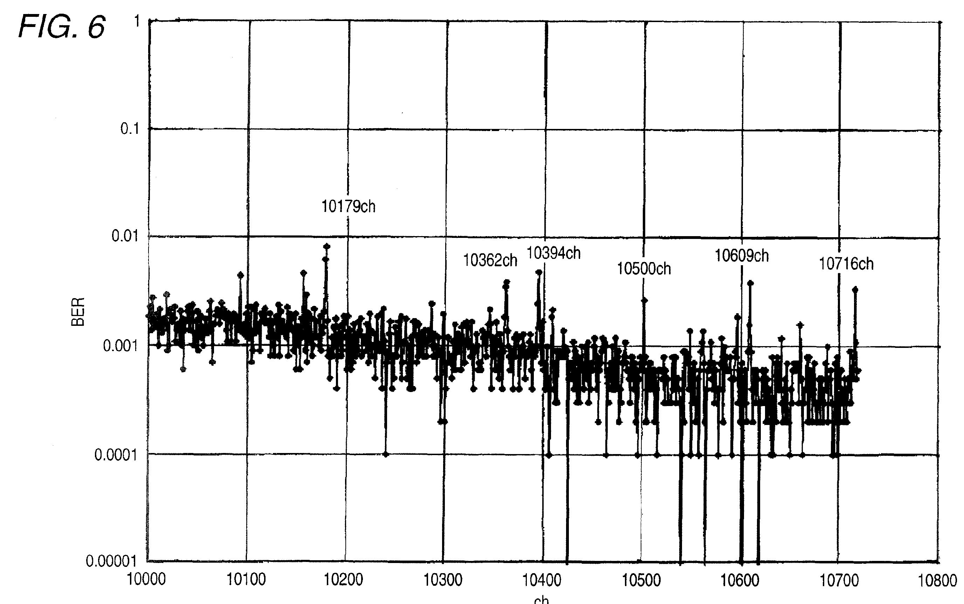

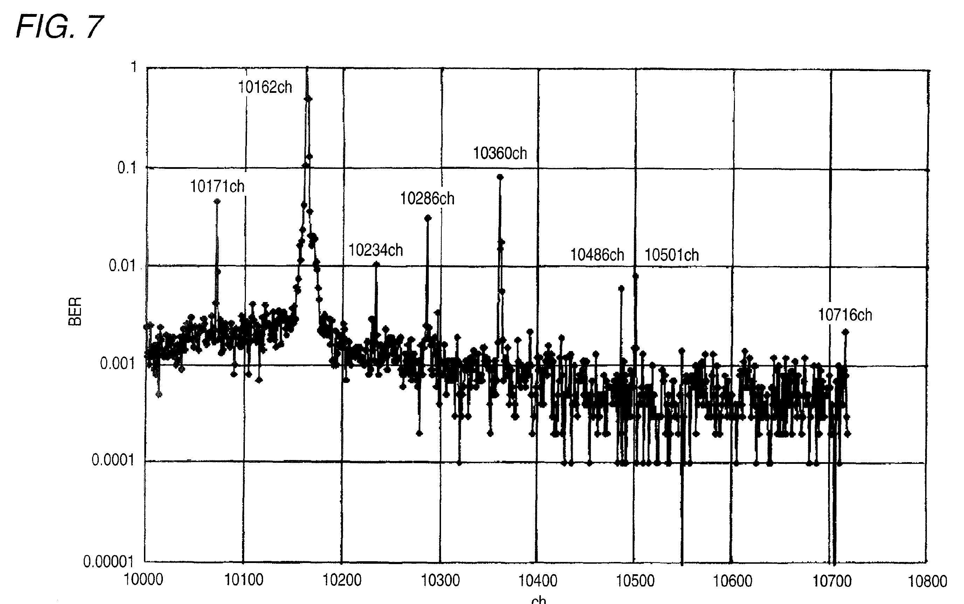

Fig. 6 shows the measurement result of the antenna BER characteristics in the case where the circuit board device according to the embodiment is applied to a radio circuit. For the sake of comparison, Fig. 7 shows the measurement result in the case where the antenna BER characteristics is measured under the same condition when the circuit board of the related art corresponding to the one shown in Fig. 8 is applied to the radio circuit of a mobile phone.

In each of Figs. 6 and 7, an ordinate represents a channel and an abscissa represents the antenna BER. When these figures are compared, it is shown that the output amount of spurious is smaller in the case of the invention shown in Fig. 6 as compared with the case of the related art shown in Fig. 7, which represents that the antenna BER characteristics of the invention is good. The fact that the output amount of spurious is small means that the noise generated from the electronic part unlikely leaks to the outside due to the shield effects of the inter-board coupling connector according to the invention. As a result, an antenna is unlikely affected by the noise and so the antenna BER characteristics is improved.

If the antenna BER characteristics is bad, a correct signal can not be recognized and so a line may be disconnected with a high possibility at a place where the electric field strength is small. In contrast, if the antenna BER characteristics is good, even at a place where the electric field strength is small, a correct signal can be recognized and so a line is hardly disconnected and the communication quality can be improved.

Although the invention is explained in detail and with reference to the particular embodiment, it will be apparent for those skilled in the art that various changes and modifications may be made without departing from the spirit and scope of the invention. This application is based on Japanese Patent Application No. 2005-055552 filed on March 1, 2005, the content of which is incorporated herein by reference.

<Industrial Applicability>

The invention relates to the connector with the shield and the circuit board device using the connector with the shield and, particularly, can be utilized in an electronic device used in a high-frequency range such as a mobile phone.

**Claims**

1. An inter-board coupling connector comprising:

   an inter-board coupling connector main body in which two boards opposing to each other are electrically coupled by a plurality of coupling terminals and the plurality of coupling terminals are molded by insulative resin to form a frame-shaped housing; and
   a shield plate provided at an outer periphery of the inter-board coupling connector main body, thereby to provide an electric shielding property between the plurality of coupling terminals and an outside of the inter-board coupling connector main body, wherein
   each of the plurality of coupling terminals is formed by a single metal piece in a manner that the each coupling terminal has flat portions to be joined to the two boards opposing to each other, respectively, and the flat portions protrude from the housing.

2. The inter-board coupling connector according to claim 1, wherein a space serving as a solder width is provided between the flat portion of the coupling terminal and the housing.

3. The inter-board coupling connector according to claim 1 or 2, wherein the coupling terminal is formed by phosphor bronze which is subjected to a nickel plating to form a lower layer and subjected to a tin plating to form a major surface layer, and liquid crystal polymer (LCP) is used as the resin.

4. A circuit board device comprising:

   the inter-board coupling connector according to one of claims 1 to 3;
   a first printed board on which electronic parts are mounted within the frame of the inter-board coupling connector; and
   a second printed board disposed in opposite to the first printed board and coupled thereto via the inter-board coupling connector;, wherein
   a wiring shield is provided on a major surface layer of the first printed board and on an inner layer of the second printed board, and
   the electronic parts are surrounded by the inter-board coupling connector and the wiring shields of the first printed board and the second printed board.

5. A circuit board device according to claim 4, wherein an inner via is provided at the first printed board or the second printed board thereby to couple to the coupling terminal of the inter-board coupling connector.

## FIG. 1

## FIG. 2 (a)          FIG. 2 (b)

FIG. 3 (a)

FIG. 3 (b)

FIG. 4

| PART | TERMINAL NUMBER | | |
|------|------|------|------|
| P1 | ② | ⑤ | ⑥ |
| P2 | ① | ② | ⑤ |
| P3 | ④ | ⑦ | ⑧ |
| P4 | ② | ③ | ④ |

*FIG. 5 (a)*

*FIG. 5 (b)*

FIG. 6

EP 1 821 368 A1

EP 1 821 368 A1

*FIG. 7*

FIG. 8 (a)

FIG. 8 (b)

## FIG. 9 (a)

## FIG. 9 (b)

## FIG. 10

14

| INTERNATIONAL SEARCH REPORT | | International application No. |
|---|---|---|
| | | PCT/JP2006/303764 |

A.  CLASSIFICATION OF SUBJECT MATTER
**_H01R12/04_**(2006.01), **_C25D7/00_**(2006.01), **_H01R12/16_**(2006.01), **_H01R13/03_**
(2006.01), **_H01R13/46_**(2006.01), **_H05K1/14_**(2006.01)

According to International Patent Classification (IPC) or to both national classification and IPC

B.  FIELDS SEARCHED

Minimum documentation searched (classification system followed by classification symbols)
**_H01R12/04_**(2006.01), **_C25D7/00_**(2006.01), **_H01R12/16_**(2006.01), **_H01R13/03_**
(2006.01), **_H01R13/46_**(2006.01), **_H05K1/14_**(2006.01)

Documentation searched other than minimum documentation to the extent that such documents are included in the fields searched
Jitsuyo Shinan Koho       1922-1996   Jitsuyo Shinan Toroku Koho   1996-2006
Kokai Jitsuyo Shinan Koho  1971-2006   Toroku Jitsuyo Shinan Koho   1994-2006

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| Y | JP 2001-111232 A  (Sony Corp.),<br>20 April, 2001 (20.04.01),<br>Full text; Figs. 1 to 10<br>(Family: none) | 1-5 |
| Y | JP 6-204642 A  (Matsushita Electric Industrial Co., Ltd.),<br>22 July, 1994 (22.07.94),<br>Full text; Figs. 1 to 13<br>(Family: none) | 1-5 |
| Y | JP 2001-053457 A  (Kitakawa Kogyo Kabushiki Kaisha),<br>23 February, 2001 (23.02.01),<br>Par. No. [0035]<br>(Family: none) | 3 |

☒  Further documents are listed in the continuation of Box C.    ☒  See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered   to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>17 March, 2006 (17.03.06) | Date of mailing of the international search report<br>28 March, 2006 (28.03.06) |
|---|---|
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2006/303764

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2004-221049 A  (DDK Ltd.),<br>05 August, 2004 (05.08.04),<br>Par. No. [0012]; Figs. 1, 2, 4, 6<br>(Family: none) | 3 |
| Y | JP 7-176846 A  (Matsushita Electric Industrial Co., Ltd., DDK Ltd., Dowa Mining Co., Ltd.),<br>14 July, 1995 (14.07.95),<br>Par. Nos. [0002], [0041] to [0047]; Figs. 1 to 4 | 5 |
| Y | JP 2002-368043 A  (Matsushita Electric Industrial Co., Ltd.),<br>20 December, 2002 (20.12.02),<br>Par. No. [0003]; Figs. 1, 4, 5<br>(Family: none) | 5 |
| A | JP 2004-327641 A  (TDK Corp.),<br>18 November, 2004 (18.11.04),<br>Full text; all drawings | 1,4,5 |
| A | JP 2004-190065 A  (FCM Co., Ltd.),<br>08 July, 2004 (08.07.04),<br>Full text; all drawings | 3 |
| A | JP 8-050967 A  (Methode Electronics Inc.),<br>20 February, 1996 (20.02.96),<br>Par. Nos. [0002] to [0004], [0016]; Fig. 1 | 3 |
| A | JP 2002-117920 A  (Fujitsu Hitachi Plasma Display Ltd.),<br>19 April, 2002 (19.04.02),<br>Par. No. [0022]; Figs. 5 to 8 | 3 |

Form PCT/ISA/210 (continuation of second sheet) (April 2005)

**INTERNATIONAL SEARCH REPORT**
Information on patent family members

International application No.

PCT/JP2006/303764

| | | | |
|---|---|---|---|
| JP 2001-111232 A | 2001.04.20 | (Family: none) | |
| JP 6-204642 A | 1994.07.22 | (Family: none) | |
| JP 2001-053457 A | 2001.02.23 | (Family: none) | |
| JP 2004-221049 A | 2004.08.05 | (Family: none) | |
| JP 7-176846 A | 1995.07.14 | US 5652042 A | 1997.07.29 |
| | | US 5733467 A | 1998.03.31 |
| | | US 5914358 A | 1999.06.22 |
| | | US 5977490 A | 1999.11.02 |
| | | EP 0651602 A1 | 1995.05.03 |
| JP 2002-368043 A | 2002.12.20 | (Family: none) | |
| JP 2004-327641 A | 2004.11.18 | EP 1471604 A1 | 2004.10.27 |
| JP 2004-190065 A | 2004.07.08 | US 2004-0038072 A1 | 2004.02.26 |
| | | EP 1391969 A2 | 2004.02.25 |
| JP 8-050967 A | 1996.02.20 | US 5599595 A | 1997.02.04 |
| | | US 5688146 A | 1997.11.18 |
| | | GB 2284566 A | 1995.06.14 |
| | | DE 4443410 A1 | 1995.06.14 |
| | | FR 2713830 A1 | 1995.06.16 |
| JP 2002-117920 A | 2002.04.19 | US 2002-0041155 A1 | 2002.04.11 |
| | | EP 1195791 A2 | 2002.04.10 |

Form PCT/ISA/210 (patent family annex) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 10041669 A
- JP 2001244027 A
- JP 2005055552 A